# EUROPEAN PATENT APPLICATION

(11) **EP 0 695 814 A1**
(43) Date of publication of application: **07.02.1996**
(21) Application number: 95305217.2
(22) Date of filing: 26.07.1995
(51) Int. Cl.: C23C 14/00, C23C 14/54

(54) **Thin film sputtering**

(30) Priority: 02.08.1994 US 284839
(71) Applicant: THE BOC GROUP, INC., Murray Hill, New Jersey 07974 (US)
(72) Inventor: Zarrabian, Sohrab, Summit, New Jersey 07901 (US); Terry, Robert, Livermore, California 94550 (US); Wolfe, Jesse D., Fairfield, California 94533 (US)
(74) Representative: Bousfield, Roger James

(57) **Abstract**

A method of sputtering material on to a substrate (19) within a vacuum chamber (40) from a target surface (17) composed substantially entirely of a non-electrically conductive element, comprising the steps of:
introducing into the vacuum chamber a combination of gases which includes at least one gas (67) that reacts with the target element and a combination of at least first and second noble gases (63, 65),
causing the partial pressure of the first noble gas (63) to be within a range of from 20 to 80 percent of a total partial pressure of the combination of the at least first and second noble gases within the vacuum chamber, and
maintaining relative proportions of the at least one reactive gas and a total of the combination of the at least first and second noble gases flowing (31) in to the vacuum chamber in order to operate (49) with a partial pressure within the vacuum chamber of the at least one reactive gas being equal to substantially zero.

## Description

This invention relates to processes of depositing films on substrates by magnetron sputtering in a vacuum, and, more specifically, to such processes used to deposit non-conducting or semi-conducting elements, such as silicon, and dielectrics of such elements.

Various magnetron sputtering processes are utilised to deposit thin films on a wide variety of substrates. One class of such processes is utilised to form optical films on glass substrates. Such substrates include large scale architectural glass used for windows of buildings, vehicle glass such as truck and automobile windshields, computer and video display screens, and small optical elements. This class of processes is carried out by passing a series of one type of such substrates through a vacuum chamber in which material is sputtered from a target that is being bombarded with ions generated in a plasma discharge. If it is desired that the thin film be composed of the target material alone, that material is sputtered directly onto the substrates.

On the other hand, it is often desired to deposit a compound of which the target element is a part, and this is accomplished by introducing a reactive gas into the vacuum chamber that reacts with the sputtered element on the surface of the substrate to form the desired compound. One example of reactive sputtering is in the deposition of dielectric films, where the target material is a metal, such as titanium, and the reactive gas is oxygen or nitrogen. In another example, a target of a predominately non-conductive or semi-conductive element is used, such as silicon, which is sputtered away and combined with a reactive gas, such as oxygen, to deposit a film of a dielectric material, such as silicon dioxide. The demand for sputtered films of non-metallic, substantially non-conductive elements, or dielectric compounds thereof, has increased significantly in recent years. However, it is difficult to control current sputtering processes that deposit such films. These processes generally cannot be operated in a stable manner. The deposition of silicon dielectric films is the most difficult, and, at the same time, the demand for such films is increasing rapidly. Existing processes provide a rate of deposition that is much less than that which is obtained when forming films of most metals.

In order to be cost effective, the substrates must be passed through the magnetron sputtering equipment at a high rate. That means that the rate at which such material is deposited on the substrate needs to be maintained at a high level, but that has not been the case when depositing silicon oxide and other such films. Silicon oxide films are becoming popular for use as one or more layers of a multi-layer "stack" formed on glass in order to provide wavelength selective transmission and/or reflection characteristics. The refractive index of silicon dioxide is low. However, the rate of depositing such films is of particular concern when coating large substrates, such as building or automobile glass. The required capital investment in equipment is very large and thus it is desired to be able to move the substrates through the a usual line of sputtering vacuum chambers at an adequate rate of speed.

The primary undesirable effect which occurs during the deposition of films of silicon or a silicon dielectric is arcing. Frequent arcing causes the process to drift away from the desired operating parameters. Two types of arcing occur. In a first type, which is the main concern, an arc occurs through the plasma, which is a conductor of electrons, from the target surface to an anode surface. The non-electrically conductive target material is doped with some conductive material, such as some aluminum within a silicon target, in order to allow it to serve as the cathode of the plasma process. But since any significant amount of the conductive material in the deposited film is undesirable, the small amount of conductive material in the target results in the target having a much higher level of electrical resistance through its thickness than in the case when a conductive material is being sputtered from a metal target material.

An equivalent electrical series "circuit" exists within the deposition chamber between a metal electrode surface contacting a backside of the target and an anode spaced apart from the exposed target surface. This series circuit includes the high resistance of the target material itself, thus forming a voltage drop through the thickness of the target material, the cathode sheath immediately adjacent the target surface and then the plasma itself between the sheath and the anode. The arcing of this first type that exists with substantially non-conductive target materials is believed to have two causes that work together. One is that the target operates at a higher temperature due to its high resistance, thus making it easier for electrons to escape from the target surface. The other cause is believed to be a larger voltage drop across the cathode sheath, thus causing ions in that region to impact the target surface with higher energy, thus resulting in more electrons being dislodged from the target surface. An increased population of electrons increases the probability of a lightning type of arc occurring between the target surface and the anode, resulting in a very large current flowing through this series circuit. The power supply connected between the electrode surface behind the target and the anode is often disabled for a time. This makes it very difficult, if not impossible, to maintain operation of the process with the stable parameters that provide a high deposition rate. These arcs also tend to dislodge particulate material which can undesirably become part of the deposited film.

As a cause of the second type of arcing, silicon dioxide or other non-conductive material is not only deposited on the substrate where it is desired but also on other surfaces within the vacuum chamber, including the anode and target across which an electrical power supply is connected, and other surfaces adjacent the target. Periodically, a charge is built up across this dielectric film sufficient to break it down, resulting in an arc occurring. This can cause some disruption in the sputtering process and also generates particles within the vacuum chamber, some of which become attached to the substrate surface.

Many significant improvements have been made in processes of depositing silicon dioxide and other troublesome dielectrics, in order to avoid this second cause of arcing. One such advance is to form the silicon target in a cylindrical shape and then rotate the cylinder about its axis during the deposition process. Oxides formed on the target surface are then sputtered off, providing a type of self-cleaning feature. Other improvements have been made in shields that cover surfaces adjacent the target. Further improvements include anode shaping and positioning. However, these measures to not reduce the causes of the first type of arc (between the target surface and the anode) discussed above.

Therefore, the present invention is concerned with the improvement of such sputtering techniques in order significantly to reduce the probability of target-to-anode arcing, to operate such a deposition process in a stable manner and, generally to increase the rate of deposition of high quality films.

Specifically, the invention is concerned with improving the processes of depositing silicon compounds forming dielectric layers.

In accordance with the invention, there is provided a method of sputtering material on to a substrate (19) within a vacuum chamber (40) from a target surface (17) composed substantially entirely of a non-electrically conductive element, comprising the steps of:
introducing into the vacuum chamber a combination of gases which includes at least one gas (67) that reacts with the target element and a combination of at least first and second noble gases (63, 65),
causing the partial pressure of the first noble gas (63) to be within a range of from 20 to 80 percent of a total partial pressure of the combination of the at least first and second noble gases within the vacuum chamber, and
maintaining relative proportions of the at least one reactive gas and a total of the combination of the at least first and second noble gases flowing (31) in to the vacuum chamber in order to operate (49) with a partial pressure within the vacuum chamber of the at least one reactive gas being equal to substantially zero.

Generally, a target of a material that is not electrically conductive, or is at most semi-conductive, used to deposit a film of that material, or a dielectric compound of such a material, in an atmosphere including at least two different noble gases. For example, when depositing silicon based dielectric compounds, sputtering occurs from a silicon target within a magnetron vacuum chamber having an atmosphere of one or more reactive gases (usually oxygen and/or nitrogen) and two different noble gases. One specific combination of noble gases includes argon with its partial pressure maintained in the chamber within a range of from 20-80 percent of the total partial pressure of the noble gases, the balance being made up of either helium or neon, or a combination of helium and neon. Other noble gases include krypton, xenon and radon, but these gases are generally not utilized because of their unavailability, high cost or difficulties in use.

The relative partial pressures of the noble gases can be maintained by controlling the flow of the individual gases from separate sources into the chamber with corresponding relative rates of flow. Alternatively, the noble gases can be premixed in a proportion corresponding to the desired relative partial pressures and then introduced into the vacuum chamber from a single container.

A noble gas is commonly used during the sputtering of metal films from a target of the metal. A noble gas is also used in some reactive sputtering, in combination with a reactive gas, in order to increase the rate of deposition. Indeed, an inert gas has also been mixed with oxygen during the deposition of silicon dioxide in order to improve its rate of deposition. However, it was found that the presence of a noble gas did not improve the controllability and stability of the process, and, in most cases, degraded the process in this regard. Therefore, silicon dioxide is now usually deposited without use of an inert gas, only oxygen being used. However, it has been found, as part of the present invention, that the benefits of use of an inert gas can be obtained when a combination of two noble gases are utilized instead of just one. Generally, the noble gas with the lower atomic number makes up the majority of the volume of noble gases.

It has been found that the proper combination of at least two noble gases greatly reduces the incidence of target-to-anode arcing, thus allowing a given process to be controlled to operate in a stable manner to provide a maximum deposition rate. This beneficial result is believed to be due to a transfer of energy between metastable states of the noble gases and the surface of the target. This helps to reduce the impedance of the cathode sheath, which thus reduces the voltage drop across the sheath, resulting in a reduced probability of target-to-anode arcing. Ions within the sheath do not then strike the target with such a high energy level. The reduced arcing and resulting reduction in voltage fluctuations allow the process to be controlled by an automatic feedback control loop to function at the desired operating point in a stable manner. It has previously been thought that such a control system could not be utilized when depositing films from a target of silicon, or of other non-conductive or semi-conductive materials.

Reference will now be made, by way of exemplification only, to the accompanying drawings, in which:
Figure 1 schematically illustrates magnetron sputtering apparatus of a type in which the present invention constitutes an improvement;
Figure 2 is a cross-sectional view of a portion of the system of Figure 1, taken at section 2-2 thereof;
Figure 3 is a curve illustrating a desired operating point for the apparatus of Figures 1 and 2;
Figure 4 schematically illustrates a system for controlling the magnetron apparatus of Figures 1 and 2;
Figure 5 shows curves which illustrate a method of determining operating parameters of the system of Figures 1 and 2 according to the present invention; and
Figure 6 shows a curve that illustrates an optimum operating point of the system of Figures 1 and 2.

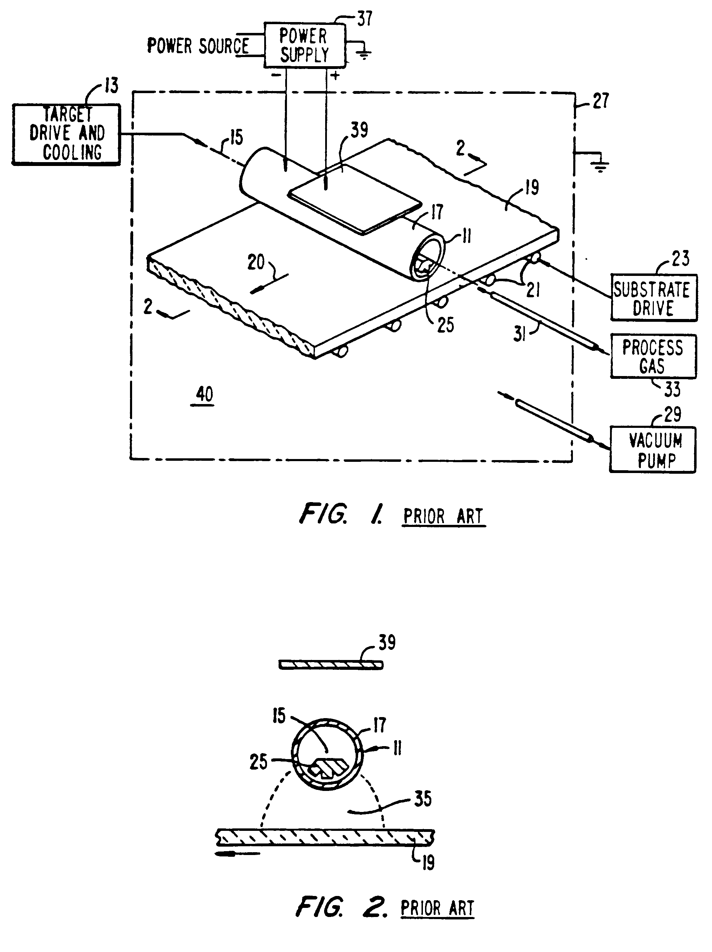

Referring initially to Figure 1, as a starting point, one example of sputtering apparatus and a process as currently practised is described. The magnetron shown in Figure 1 is a type utilising a cathode 11 having an elongated cylindrical shape that is rotated by an electrical motor drive source 13 at a uniform speed about an axis 15. Carried on the cylindrical outside surface of the cathode 11 is a layer of target material 17 that is sputtered away during the deposition process. A substrate 19 is moved along a path 20 that is perpendicular to the axis 15 of rotation of the cathode 11. The substrate is moved in one direction along that path by some convenient mechanism, such as supporting rollers 21 which are driven by an electrical drive motor 23. An elongated permanent magnet structure 25 is positioned within the cathode 11 and faces toward the substrate 19 that is being coated. The magnet structure 25 does not rotate with the target 11 but its stationary position can often be rotatably adjusted somewhat. The magnet structure 25 contains magnets continuously along its length. This length determines the width of a deposition zone. The width of the substrate 19 is slightly less, as a maximum, than the length of the magnetic structure 25.

The deposition process takes place within a vacuum chamber 40 generally formed by metallic walls, as schematically indicated by the dashed line 27 of Figure 1. A vacuum pump system 29 maintains the pressure within the chamber at a low level consistent with the process being performed. A process gas is delivered into the chamber 40 by a tube 31, or other form of conduit, from a supply 33.

The class of magnetron illustrated in Figures 1 and 2 is electrically powered by direct current (DC) power supply 37. Another class of magnetrons utilise various forms of alternating or pulsed current. The various aspects of the present invention also have applicability to that type of magnetron. But in the one illustrated in Figures 1 and 2, the cathode 11 is connected to a negative voltage relative to that of the chamber walls 27, which are generally maintained at ground potential. Material used for the target 17 is also made to be electrically conductive so that the outside surface of the target material is also maintained at a negative voltage.

Very often, the inside surfaces of the metallic vacuum chamber walls 27 are used as the anode for the sputtering apparatus. In this case, the walls are still maintained at ground potential. Alternatively, others utilize a separate anode 39 positioned on an opposite side of the cathode 11 from the deposition zone 35. The anode 39 is then maintained at a positive voltage by connection to the power supply 37.

In the example being described, the target material 17 consists essentially of silicon. It is desired that the target 17 includes only the silicon element but since it is non-conducting, a small percentage of an electrically conductive element, such as aluminium, is mixed with the silicon. The percentage of aluminium is generally in the range of about 2-10 percent by weight. Since aluminum atoms are also sputtered off of the target along with the silicon atoms, only enough aluminium is included to give the target material a level of electrical conductivity necessary for operation of the magnetron. Such a low proportion of conductive material does not seem to affect the films that are deposited. Such a target is referenced herein as "substantially" pure silicon.

If the film being deposited is silicon itself, the process gas introduced into the chamber 40 through the conduit 31 is a combination of at least two noble gases, according to the present invention. No reactive gas is introduced, the only gases maintained in the chamber 40 being inert. However, if it is a compound of silicon that is to be deposited as a film on the substrate 19, one or more reactive gases is also introduced with the noble gases through the conduit 31, or a separate conduit (not shown). For example, if a film of silicon dioxide is being deposited on the substrate 19, oxygen is introduced into the chamber 40 as the reactive gas. If silicon nitride is being deposited as the film, on the other hand, then nitrogen is the reactive gas introduced into the chamber 40. More than one reactive gas can be used, depending upon the specific film being deposited. The reactive gas chemically reacts at the surface of the substrate 19 with atoms of silicon sputtered off of the target 17 in order to form the dielectric or other compound that is being deposited. The deposition is carried on within the chamber 40 at a very low pressure, generally within a range of 1-10 milli-Torr.

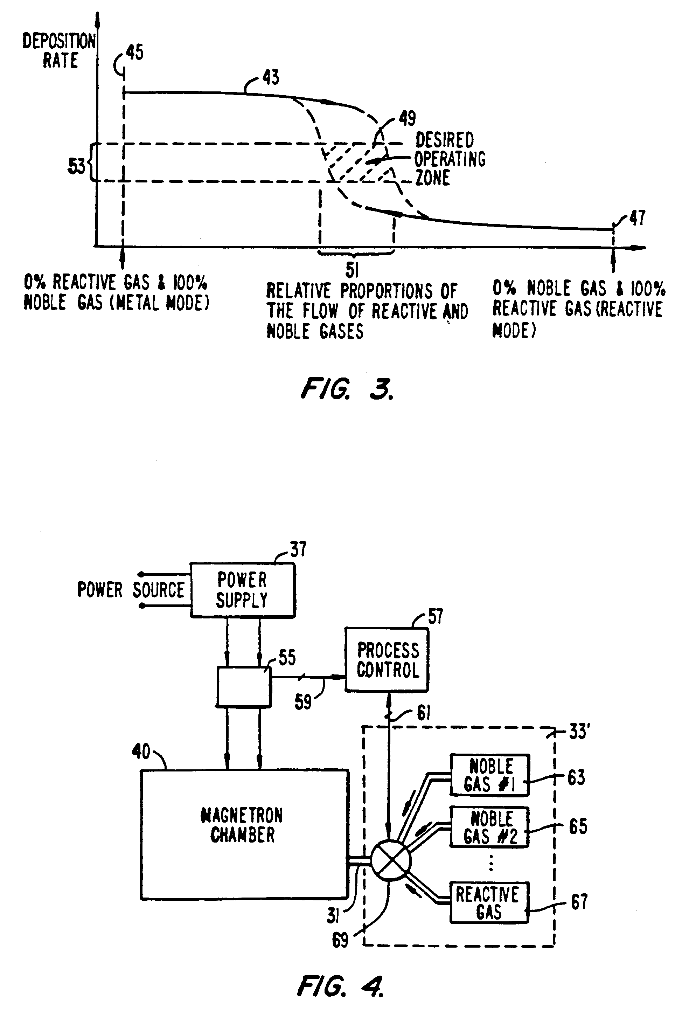

Before discussing the specifics with regard to mixing two or more noble gases together, other process parameters involved in the deposition of a dielectric such as silicon dioxide are explained with respect to Figure 3. The deposition rate is shown in the vertical axis while the relative proportions of flows of reactive and noble gases are shown along the horizontal axis. A curve 43 shows the effect of changes in the relative proportions of reactive and noble gases on the deposition rate. At one extreme 45, the deposition rate is the highest when the atmosphere within the chamber 40 is 100 percent noble gases, there being no reactive gas introduced. At an opposite extreme 47, the deposition rate is the lowest when the atmosphere within the vacuum chamber 40 is only reactive gas, no noble gas being introduced. The preferred operating zone for a reactive sputtering process is indicated by a shaded area 49, in a hysteresis portion of a curve 43. That is, the region of a preferred operating range 51 is somewhere intermediate of its extremes at the ends 45 and 47 of the curve 43. This region is characterized by high deposition rates and a fully reacted thin film deposited on the substrate.

The relative percentages of reactive and noble gases within that range result in the partial pressure of the reactive gas within the chamber 40 being substantially zero. That is, essentially all of the reactive gas introduced into the chamber is reacting with silicon atoms. This preferred range can be determined by measuring the amount of material deposited on a substrate during a certain period of time for various proportions of reactive and noble gases. Alternatively, a quantity proportional to deposition rate may be monitored in real time. One such quantity that exists in some processes is the intensity of one or more particular emission lines of the plasma. Plasma intensity is then the quantity on the vertical axis of Figure 3. Real time monitoring makes it possible, if the particular process allows it, to provide automatic control of the relative proportions of the reactive and noble gases flowing into the reaction chamber in order to maintain deposition rate within a range 53. As mentioned above, silicon processes have not been stable enough to allow such automatic control but the increased stability resulting from application of the present invention now permits it.

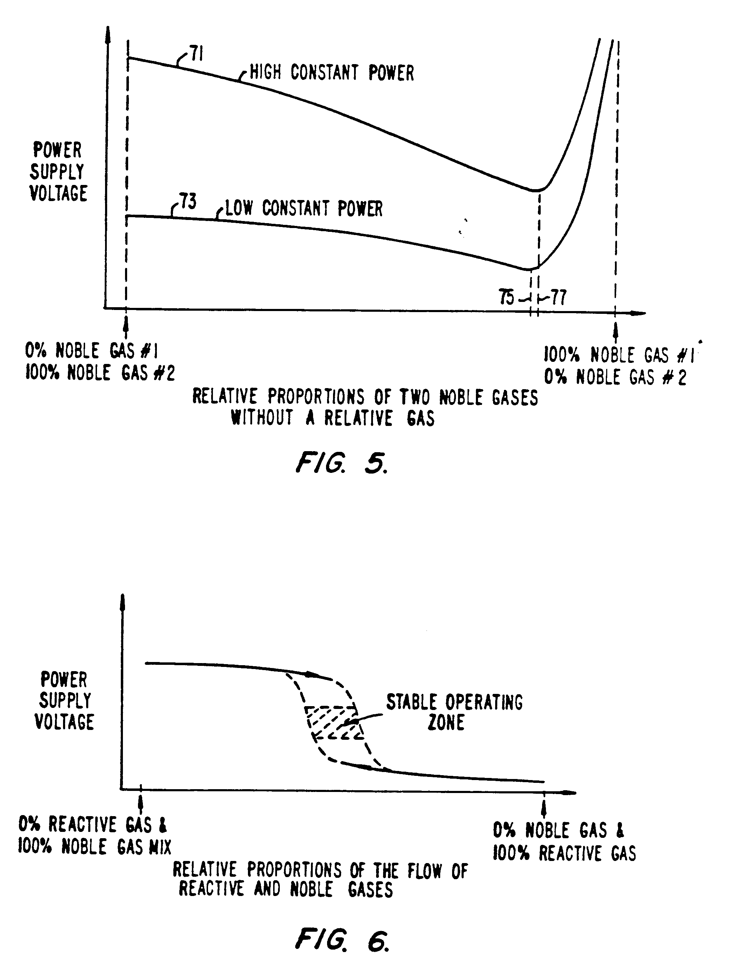

A sputtering system that provides for the control described with respect to Figure 3, as well as controlling relative proportions of two or more noble gases in accordance with the present invention, is described with respect to Figure 4. In this example, particularly for silicon processes, some characteristic of the power being supplied to the magnetron chamber 42 is monitored, rather than the intensity of a plasma emission line. This is accomplished by introducing a circuit 55 in the path of the lines from the power supply 37, or by connection with the power supply directly (not shown). A process controller 57 receives, over lines 59, a signal representing one or more of the voltage, current or power being supplied to the magnetron cathode 17 within the chamber 40. The process controller 57 controls, through line 61, the relative proportion of the various gases from a source 33' of gases that is introduced into the chamber 40. The purpose of the control system is to maintain operation with a minimum system impedance. By monitoring power supply voltage, for example, as shown in Figure 6, the relative percentages of reactive and noble gases are controlled in this manner, in order to maintain operation in the desired stable operating zone. One advantage of the present invention is that, by allowing the use of noble gases in reactive sputtering of silicon, the process can be automatically maintained in the desired operating zone. This cannot occur when the atmosphere within the chamber includes only a reactive gas such as oxygen.

The present invention provides a greater improvement when the power supply 37 is of a DC type, since the arcing problems are most severe, but also provides improved operation when the power supply 37 provides alternating current (AC) to the magnetron 40.

The supply 33' of gases introduced into the magnetron chamber 40 includes a supply 63 of a first noble gas, a supply 65 of the second noble gas, and a supply 67 of reactive gas. Other reactive and/or noble gases can be employed and introduced into the magnetron chamber 40 at the same time. A valve and flow meter system 69 both measures the flow of the individual gases from the various supplies into the chamber and provides for valve control of those flows. The process controller 57 receives, over lines 61, information of the individual gas flows and provides, over the same line 61, control signals to operate the individual gas supply valves. In the example of depositing silicon dioxide film, the reactive gas source 67 includes oxygen, one of the noble gas sources 63 or 65 contains argon, and the other of the sources 63 or 65 contains either helium, neon or both. Alternatively, another source of noble gas can be included so that both helium and neon are combined with the argon for use within the magnetron chamber 40.

The effect of different combinations of noble gases and a procedure for determining the relative proportions of each of two different noble gases to be used, will be explained with respect to the curves of Figure 5. Curves 71 and 73 show the effect on power supply voltage, when the total power from the power supply is maintain constant, as the relative proportions of two different inert gases are varied. These curves approximate what occurs with a silicon target and no reactive gas, where the noble gas No.1 is either helium or neon and noble gas No.2 is argon. The interesting effect illustrated in Figure 5 is that the voltage varies considerably as a function the relative proportions of noble gases Nos.1 and 2, particularly at high power which is usually desired in order to obtain a high deposition rate. An optimum operating point, from a theoretical point of view, is that a relative mixture indicated at 75, when operating at the low power of the curve 73, or at 77, when operating on the higher power curve 71. It is the reduced power supply voltage that minimizes the probability of arcs occurring while, at the same time, resulting in a maximum current for the given constant power. The system follows a fundamental electrical relationship of the total power supplied to the magnetron being equal to the voltage applied across the target and anode, multiplied by the current so supplied (P = V x I).

Since these exact minima of the curves 71 and 75 may not be easily maintained in commercial sputtering applications, operation is maintained within a range of different proportions of noble gases Nos.1 and 2. In the case of films of silicon or silicon compounds, the noble gas with the lowest atomic number will generally constitute the majority. Helium (atomic number of 2) and neon (atomic number of 10) are both lower in atomic number than argon (atomic number 18). An operable range, however, has been found to be broader than that, namely 20 to 80 percent of the noble gases being argon and the balance being either neon or helium or a combination of neon and helium.

Once one or more curves of the type shown in Figure 5 are determined for a particular target material in a particular magnetron sputtering system, a proportion of two or more different noble gases is established. It is then known that the partial pressures of each of the noble gases within the magnetron chamber 40 maintain that given percentage with respect to the partial pressure of all of the noble gases within the chamber. These relative partial pressures are maintained by the process controller 57 (Figure 4) controlling the rates of flow of the two or more noble gases into the chamber 40 with the determined relative proportions. Once determined, those relative proportions remain fixed while the process controller 57 varies the relative proportion of all noble gases and the reactive gases in accordance with the relationship of Figure 6, in order to maintain operation within the stable zone. As an alternative to the use of separate sources of each of the noble gases, they may be premixed in a single container that is then used as the sole source of the noble gases.

It can be seen from the curves of Figure 5 that a combination of two noble gases results in the ability to operate the magnetron with a voltage that is significantly less than if only one of the noble gases is utilized. Indeed, it is advantageous to be able to reduce that voltage, for a given constant power, by as little as 2 percent. Even such a small decline in voltage decreases the probability of arcs occurring. A decrease of 10 percent or more in operating voltage brings about an extremely large improvement in the sputtering operation.

Although the method of determining a range of useful mixtures of two different noble gases has been described with respect to Figure 5 by holding the power constant and measuring the voltage, the same effects can be obtained by controlling and monitoring other combinations. For example, rather than measuring voltage when the power is constant, the current supplied to the magnetron chamber 40 can be measured. The current reaches a maximum where the voltage of the curves of Figure 5 are a minimum. Operation is then controlled in order to obtain a higher operating current than possible with use of only one noble gas. Similarly, the voltage of the system can be maintained constant by the power supply 37 and operation set for a low power or high current. Lastly, the current to the magnetron cathode 17 can be maintained constant, operation being set at a reduced voltage or increased power as a result of mixing two noble gases together.

## Claims

1. A method of sputtering material on to a substrate (19) within a vacuum chamber (40) from a target surface (17) composed substantially entirely of a non-electrically conductive element, comprising the steps of:
introducing into the vacuum chamber a combination of gases which includes at least one gas (67) that reacts with the target element and a combination of at least first and second noble gases (63, 65),
causing the partial pressure of the first noble gas (63) to be within a range of from 20 to 80 percent of a total partial pressure of the combination of the at least first and second noble gases within the vacuum chamber, and
maintaining relative proportions of the at least one reactive gas and a total of the combination of the at least first and second noble gases flowing (31) in to the vacuum chamber in order to operate (49) with a partial pressure within the vacuum chamber of the at least one reactive gas being equal to substantially zero.

2. A method according to Claim 1 in which the first noble gas is argon.

3. A method according to Claim 1 or Claim 2 in which the second noble gas is either helium or neon.

4. A method according to any preceding claim in which the non-electrically conductive element of the target is silicon.

5. A method according to Claim 4 in which the gas introducing step includes introducing substantially only oxygen as the at least one gas that reacts with silicon.

6. A method according to any preceding claim in which the partial pressure causing step includes causing a flow of the first noble gas into the vacuum chamber to be within a range of from 20 to 80 percent of a total flow of the combination of noble gases into the vacuum chamber.

7. A method according to Claim 6 in which the step of controlling the flow of the first noble gas into the vacuum chamber includes controlling such flow to be less than 50 percent of the total flow of the combination of noble gases into the vacuum chamber.

8. A method according to any preceding claim in which the step of maintaining relative proportions of the reactive and noble gases within the vacuum chamber includes the steps of monitoring (55) a characteristic of a plasma within the vacuum chamber, and controlling the relative proportions of the reactive and noble gases flowing into the vacuum chamber in a manner to maintain the characteristic within predefined limits (49).

9. A method according to Claim 8 in which the monitoring step includes monitoring an intensity of one or more radiation lines emitted by the plasma.

10. A method according to Claim 8 in which the monitoring step includes monitoring a characteristic of an electrical supply to the target and an anode within the vacuum chamber.
